Europäisches Patentamt

European Patent Office

Office européen des brevets

(11) Numéro de publication : **0 071 494**
**B1**

(12) **FASCICULE DE BREVET EUROPÉEN**

(45) Date de publication du fascicule du brevet :
28.05.86

(21) Numéro de dépôt : 82401158.9

(22) Date de dépôt : 24.06.82

(51) Int. Cl.⁴ : **H 01 L 21/00**, H 01 L 21/285, H 01 L 21/60

(54) Procédé de fabrication de transistors bipolaires intégrés de très petites dimensions.

(30) Priorité : 26.06.81 FR 8112604

(43) Date de publication de la demande :
09.02.83 Bulletin 83/06

(45) Mention de la délivrance du brevet :
28.05.86 Bulletin 86/22

(84) Etats contractants désignés :
DE FR GB IT NL

(56) Documents cités :
FR-A- 2 389 236
IEEE TRANSACTIONS ON ELECTRON DEVICES, vol.
ED-27, no. 8, août 1980, pages 1390-1394, New York
(USA); H. NAKASHIBA et al.: "An advanced PSA
technology for high-speed bipolar LSI".
IBM TECHNICAL DISCLOSURE BULLETIN, vol. 22,
no. 8B, janvier 1980, pages 3693-3694, New York
(USA); I. ANTIPOV: "Undercut contacts for poly Si
base".

(73) Titulaire : THOMSON-CSF
173, Boulevard Haussmann
F-75379 Paris Cedex 08 (FR)

(72) Inventeur : Roche, Marcel
THOMSON-CSF SCPI 173, bld Haussmann
F-75379 Paris Cedex 08 (FR)

(74) Mandataire : Guérin, Michel et al
THOMSON-CSF SCPI 19, avenue de Messine
F-75008 Paris (FR)

Jouve, 18, rue St-Denis, 75001 Paris, France

## Description

La présente invention concerne les technologies de fabrication des circuits intégrés, sur substrat de silicium, incorporant des transistors bipolaires de très petites dimensions.

Pour des raisons de densité d'intégration, mais aussi de rapidité de fonctionnement, on cherche à réaliser des transistors bipolaires aussi petits que possible et ayant notamment une petite surface d'émetteur, une faible épaisseur de base, et une faible distance entre l'émetteur et le contact de base. En ce qui concerne ce dernier point, il résulte de la nécessité de réduire la résistance d'accès à la base entre le contact de base et la base proprement dite. Cette résistance pourrait être réduite en augmentant le dopage de la base, mais cela conduirait à un très mauvais gain en courant du transistor.

On est donc amené, pour réaliser des transistors performants, à prévoir que la région de base se décompose en deux parties : une région de base intrinsèque peu dopée, immédiatement adjacente à la région d'émetteur, et une région de base extrinsèque, plus fortement dopée, adjacente à la région de base intrinsèque et recouverte par un contact de base. La région de base intrinsèque doit avoir une épaisseur aussi faible que possible et le contact de base doit arriver aussi près de l'émetteur que possible, en évitant évidemment tout contact avec l'émetteur. De plus, la région de base extrinsèque ne doit pas arriver en contact avec la région d'émetteur : on aurait un court-circuitage du transistor par une mauvaise jonction. Ces impératifs, appliqués à des dimensions d'émetteur de l'ordre du micromètre, nécessitent des techniques de gravure et de dopage extrêmement précises, en utilisant autant que possible des procédés d'autoalignement pour éliminer les risques d'erreur dus à la superposition imprécise de masques de gravure successifs.

On a déjà proposé des techniques de fabrication de transistors de très petites dimensions, avec une base intrinsèque de faible dopage et une base extrinsèque plus dopée, utilisant deux couches de silicium polycristallin qui réalisent un autoalignement du contact de base et de la région de base extrinsèque, ainsi qu'un autoalignement du contact d'émetteur avec la région d'émetteur.

Le brevet FR-2 389 236 décrit un procédé de fabrication dans lequel on utilise la vitesse de gravure différentielle entre de l'oxyde de silicium formé sur des flancs verticaux de silicium polycristallin et de l'oxyde de silicium formé sur des surfaces horizontales, ce dernier ayant subi une implantation d'impuretés facilitant sa gravure. L'oxyde peut être éliminé partout sauf sur des flancs verticaux où il sert à définir une couche d'isolation d'épaisseur faible. Mais cette technique permet difficilement de contrôler cette épaisseur et de lui donner une valeur très faible.

La présente invention propose un nouveau procédé de fabrication qui conserve les avantages de ces deux alignements et qui en plus permet un autoalignement de la région d'émetteur par rapport aux régions de base intrinsèque et de base extrinsèque et donc par rapport au contact de base.

Dans le procédé selon l'invention, les étapes de formation de la base et de l'émetteur du transistor bipolaire comprennent les étapes décrites dans la revendication 1.

La connexion conductrice d'émetteur est de préférence une deuxième couche de silicium polycristallin à travers laquelle on diffuse une impureté du premier type de conductivité pour former une région d'émetteur autoalignée avec son contact.

Le nitrure et l'oxyde de silicium qui subsistent, après attaque chimique, sur les bords verticaux de silicium polycristallin encadrant la région d'émetteur, définissent une épaisseur correspondant sensiblement à l'épaisseur de la base intrinsèque. D'un côté de cette épaisseur on trouve la première couche de silicium polycristallin qui constitue un contact de base autoaligné avec la région de base extrinsèque ; de l'autre, on trouve le contact d'émetteur autoaligné avec la région d'émetteur. L'épaisseur d'oxyde et de nitrure subsistant après attaque chimique établit l'autoalignement cherché entre émetteur et contact de base.

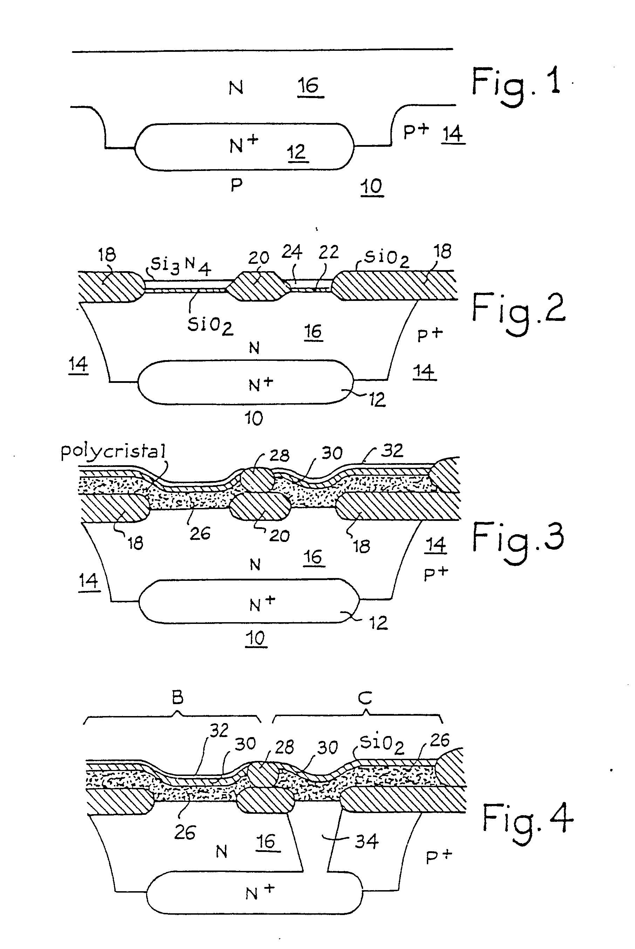

D'autres caractéristiques et avantages de l'invention apparaîtront à la lecture de la description détaillée qui suit et qui est faite en référence aux dessins annexés dans lesquels les figures 1 à 12 montrent la succession des étapes principales de fabrication d'un transistor bipolaire selon le procédé de l'invention.

Les dimensions des dessins en coupe sont sensiblement à l'échelle pour mieux faire comprendre le procédé et ses résultats.

On part d'un substrat 10 de silicium dopé avec une impureté d'un premier type de conductivité, par exemple P (résistivité de l'ordre de 3 à 20 ohms-centimètres), et on dope de manière classique avec une impureté du type opposé (N) des régions du substrat qui constitueront une couche enterrée 12 fortement dopée de type $N^+$ en dessous de chacun des transistors formés ultérieurement.

On effectue aussi de préférence, autour de chaque région de couche enterrée 12, un surdopage concentré avec une impureté de type P, dans le substrat pour servir de fondation à des régions 14 d'isolement par jonction entre transistors.

Ces fondations sont formées par implantation de bore, par exemple avec une énergie de 180 keV et une dose de l'ordre de $3 \times 10^{14}$ At/cm², à la suite de quoi on fait croître une couche épitaxiale 16 de silicium monocristallin de type N (peu dopée), d'une épaisseur d'environ 2 micromètres et d'une résistivité de 0,5 ohm-cm.

Au cours de la croissance épitaxiale et au cours des étapes de traitement thermique ultérieures, les impuretés de type N$^+$ diffusées dans le substrat, et les impuretés de type P$^+$, implantées dans les fondations d'isolement, remontent par diffusion dans la couche épitaxiale et forment respectivement les régions de couche enterrée 12 (N$^+$) et les régions 14 d'isolement par jonction (P$^+$).

On pourrait diffuser les régions d'isolement 14 par le haut après la croissance épitaxiale mais l'intérêt de la diffusion par le bas à partir de fondations P$^+$ est, d'une part, de profiter du traitement thermique de l'épitaxie pour assurer la remontée vers le haut des impuretés P$^+$, et, d'autre part, de faciliter la localisation optique du masque des régions d'isolement par rapport aux couches enterrées puisque celles-ci ne sont pas masquées par la couche épitaxiale lors de la formation des fondations P$^+$.

La figure 1 représente le substrat à cette étape.

L'isolement entre transistors est complété par une oxydation localisée de la surface de la couche épitaxiale 16 (figure 2). Cette oxydation localisée sert à former une région 18 d'oxyde superficiel épais tout autour de chaque transistor, au-dessus de la région 14 d'isolement par jonction qui entoure aussi la zone active dans laquelle est formé chaque transistor. L'isolement des zones actives les unes par rapport aux autres résulte de la combinaison des régions 18 (isolement par oxyde épais) et 14 (isolement par jonction).

Dans cette étape d'oxydation localisée, on forme également des régions d'oxyde épais 20 séparant, dans chaque zone active, une région de base (à gauche, sur la figure 2), d'une région de collecteur (à droite).

L'oxydation localisée se fait classiquement par formation d'une couche 22 d'oxyde de silicium thermique SiO$_2$ (environ 0,03 micromètre) sur la surface de la plaquette de silicium telle qu'elle se présente à la figure 1, c'est-à-dire sur la surface de la couche épitaxiale 12. Ensuite, on dépose une couche 24 de nitrure de silicium (Si$_3$N$_4$) d'environ 0,1 micromètre. Le nitrure est gravé aux emplacements des zones d'oxyde épais désirées (18 et 20). On effectue alors une oxydation thermique, qui ne se produit que là où il n'y a pas de nitrure, jusqu'à obtenir une épaisseur d'oxyde d'environ un micromètre dans les régions d'isolement 18 et 20. Cet oxyde épais est appelé oxyde de champ.

On élimine le nitrure et la fine couche d'oxyde 22 et on dépose en phase vapeur à basse pression une couche uniforme de silicium polycristallin 26 d'une épaisseur d'environ 0,5 micromètre.

On effectue à nouveau une oxydation localisée, cette fois dans le silicium polycristallin, pour former des régions d'oxyde épais 28 qui interrompent la couche 26 de silicium polycristallin et qui permettent de séparer une électrode de base (sur la gauche de la figure), et une électrode de collecteur (sur la droite) pour chaque transistor, et qui permet également de définir un motif d'interconnexions résistives en silicium polycristallin entre certains transistors, selon le circuit à réaliser.

On remarque sur la figure 3, qui représente cette deuxième étape d'oxydation localisée, qu'une région d'oxyde épais 28 est formée au-dessus de la région d'oxyde 20 qui délimitait la partie base de la partie collecteur de chaque transistor.

La deuxième oxydation localisée est effectuée sensiblement comme la première, par exemple avec une couche d'oxyde de silicium 30 d'environ 0,3 micromètre recouverte d'une couche de nitrure 32 d'environ 0,06 micromètre ; le nitrure est gravé puis une oxydation thermique est effectuée pour oxyder sur toute sa hauteur le silicium polycristallin dans les régions 28 non protégées par le nitrure.

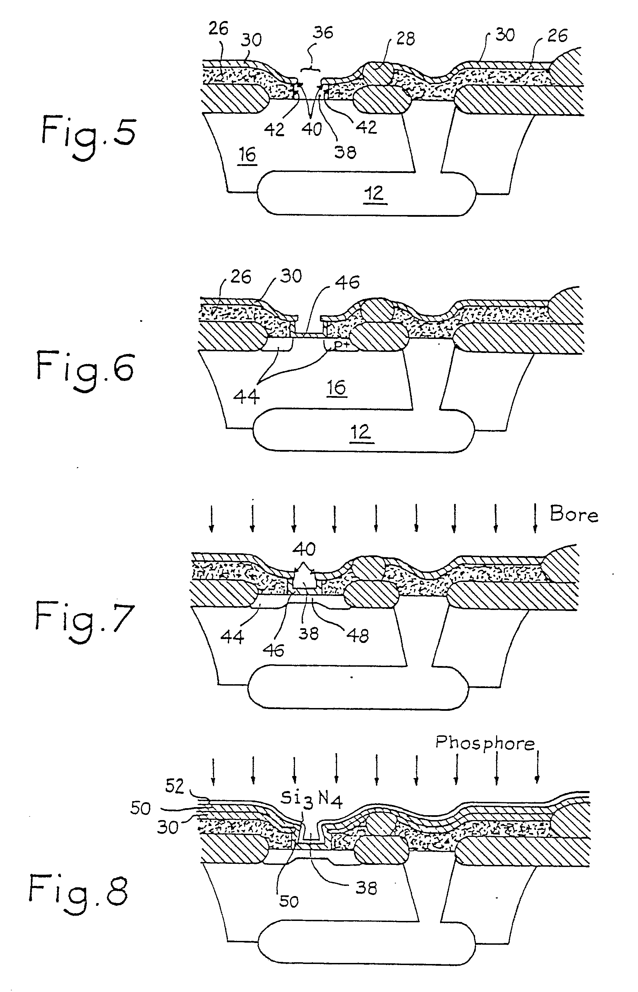

A l'aide d'un masque de sélection, c'est-à-dire un masque qui ne nécessite pas une précision de dessin et surtout de positionnement extrêmement grande, le nitrure est éliminé au niveau des électrodes de collecteur et des interconnexions (régions de silicium polycristallin C sur la figure 4).

Un dopant au phosphore est déposé et, par traitement thermique, il diffuse dans le silicium polycristallin des régions C, là où il n'y a pas de nitrure, et, là où le silicium polycristallin est en contact avec le silicium monocristallin, le phosphore diffuse aussi dans ce dernier.

On forme ainsi non seulement une électrode de collecteur et des interconnexions fortement dopées donc peu résistives, mais aussi une région 34 de type N$^+$ qui est un puits d'accès à la couche enterrée 12.

Le nitrure est éliminé de la même manière au-dessus des régions de base (partie B de la figure 4) et, après masquage des régions C par une résine, on implante du bore dans le silicium polycristallin non protégé par la résine. Le silicium polycristallin ainsi dopé par implantation servira ultérieurement de source de dopant de type P pour le silicium monocristallin.

L'implantation peut se faire en plusieurs fois pour répartir la dose implantée avec plusieurs énergies et avoir ainsi un dopage sur toute l'épaisseur de la couche 26.

Par exemple, on implantera $2 \times 10^{15}$ atomes/cm$^2$ à 100 kev, puis la même dose à 140 kev, puis encore la même dose à 180 kev. Ces implantations sont suivies d'un recuit à 900 °C pendant 25 minutes sous azote, pour uniformiser le dopage dans le polycristal.

Au lieu d'effectuer le dépôt de silicium polycristallin non dopé et ensuite un dopage au phosphore dans les régions C et une implantation de bore dans les régions B, on pourrait déposer du silicium polycristallin dopé au bore (dopage en même temps que le dépôt). Si on désire former une diffusion profonde de type N$^+$ pour le puits d'accès au collecteur (34), on dope les régions C au phosphore avec une dose suffisante pour surcompenser la dose de bore présente dans le silicium polycristallin. Si on n'a pas besoin de diffusion profonde 34, on peut prévoir que le contact de collecteur est fait non pas par la couche de silicium polycristallin 26, mais par une deuxième couche de silicium polycristallin déposée ultérieurement et servant de toute façon, comme on le verra plus loin, à faire un contact d'émetteur dopé de type N⁺. Dans ce cas, le silicium polycristallin de la couche 26 est éliminé de la région C avant le dépôt de la deuxième couche de silicium polycristallin.

Le nitrure de silicium 32 ayant été éliminé, on conserve la couche d'oxyde 30 et, à l'aide d'un masque de résine non représenté, on la grave pour définir une ouverture 36 correspondant à la position de l'émetteur et à la géométrie de celui-ci, dilatée de quelques dixièmes de micron (figure 5).

On peut aussi laisser la couche de nitrure avant de déposer le masque de résine, ce qui permet de réduire jusqu'à quelques centièmes de micromètre l'épaisseur d'oxyde qui était nécessaire pour la couche 30 sous le nitrure.

La résine est éliminée et l'oxyde découpé au niveau de l'émetteur sert lui-même de masque pour une attaque, chimique ou par plasma, du silicium polycristallin au niveau de l'ouverture 36.

L'attaque est sensiblement isotrope, c'est-à-dire que l'ouverture 38 creusée dans le silicium polycristallin de la couche 26 s'étend non seulement en face de l'ouverture 36, mais aussi légèrement en retrait au-dessous des bords de la couche d'oxyde 30 entourant l'ouverture 36. La surgravure du silicium par rapport au masque produit un léger surplomb 40 de la couche d'oxyde 30 par rapport aux bords verticaux 42 du silicium polycristallin autour de l'ouverture 36.

La gravure est effectuée de manière à éliminer le silicium polycristallin dans l'ouverture 38 en n'attaquant pas ou presque pas le silicium monocristallin qui est au-dessous. La durée de l'opération de gravure est limitée en conséquence, en fonction de l'épaisseur de silicium polycristallin et en fonction du type de gravure et des produits de gravure utilisés.

La figure 5 représente la plaquette semiconductrice à la fin de cette étape de gravure.

Un traitement thermique en atmosphère oxydante est alors effectué pour obtenir une diffusion de bore (P⁺) dans le silicium monocristallin à partir du silicium polycristallin dopé au bore en contact avec la couche épitaxiale 16. Le silicium polycristallin se comporte comme une source de dopant et forme dans le silicium monocristallin une région de base extrinsèque 44 de type P⁺ entourant l'ouverture 38 ménagée dans le silicium polycristallin.

Ce dernier constitue une électrode de base en contact avec la région de base extrinsèque 44 et il y a autoalignement entre contact de base et base extrinsèque.

Le traitement peut s'effectuer dans un four à 1 050 °C pendant 30 minutes. Il conduit à une oxydation du silicium qui est à nu, c'est-à-dire à la fois du silicium monocristallin dans l'ouverture 38 et des bords verticaux 42 du silicium polycristallin entourant cette ouverture. L'épaisseur de la couche d'oxyde 46 en forme de cuvette qui résulte de cette oxydation peut être de l'ordre de 0,1 micromètre.

Une implantation ionique d'une impureté de type P (bore) est alors effectuée, par exemple avec une énergie de 100 kev et une dose de 10¹³ atomes par centimètre carré (figure 7). Cette énergie est suffisante pour que les atomes de bore traversent la portion d'oxyde qui reste en surplomb dans l'ouverture 38.

Par cette implantation on constitue la base intrinsèque 48 du transistor, peu dopée, qui rejoint latéralement la base extrinsèque plus dopée 44, compte tenu de l'avancée latérale de la diffusion de bore par rapport au silicium polycristallin qui a servi de source de dopant.

Il reste maintenant à réaliser une région d'émetteur et un contact d'émetteur qui soient autoalignés l'un par rapport à l'autre et par rapport à la base extrinsèque, de manière à ménager une faible épaisseur de base intrinsèque entre la région d'émetteur et la base extrinsèque. Les étapes suivantes du procédé montrent comment on réalise cet autoalignement en contrôlant l'épaisseur de base intrinsèque qui subsiste.

Une couche 50 d'oxyde de silicium est déposée sur la plaquette, à basse pression pour recouvrir la totalité de la surface extérieure de celle-ci, y compris les bords verticaux entourant l'ouverture 38 (figure 8). Cette couche a une épaisseur de l'ordre de 0,5 micromètre ; cette épaisseur peut varier car c'est essentiellement par elle que l'on contrôle la distance entre émetteur et base extrinsèque. Cette couche 50 se superpose sur la majeure partie de la surface de la plaquette à la couche isolante 30 (en principe également en oxyde de silicium) qui est toujours présente (et qui a d'ailleurs un peu augmenté d'épaisseur lors du traitement thermique à 1 050 °C sous atmosphère oxydante).

On dépose ensuite, toujours à basse pression pour obtenir un bon recouvrement même sur les parois verticales, une couche 52 de nitrure de silicium d'une épaisseur de l'ordre de 0,05 micromètre.

On procède à une implantation de phosphore ou d'un autre produit capable d'augmenter la facilité de dissolution du nitrure dans une étape ultérieure d'attaque du nitrure.

Avec une implantation de 2 × 10¹⁵ atomes/cm² de phosphore sous une énergie de 50 kev, la vitesse de gravure du nitrure dans une solution de FH-H20 à un dixième est multipliée par 8. Mais la pénétration des ions de phosphore lors de l'implantation (qui est faite verticalement) est très faible au niveau des portions verticales de la couche de nitrure 52. Par conséquent, la vitesse de dissolution n'est pas augmentée dans ces portions et on peut, grâce à la sélectivité ainsi obtenue et en choisissant convenablement la durée de l'attaque du nitrure, éliminer entièrement le nitrure partout sauf sur les parois verticales de l'ouverture 38 ménagée dans le silicium polycristallin.

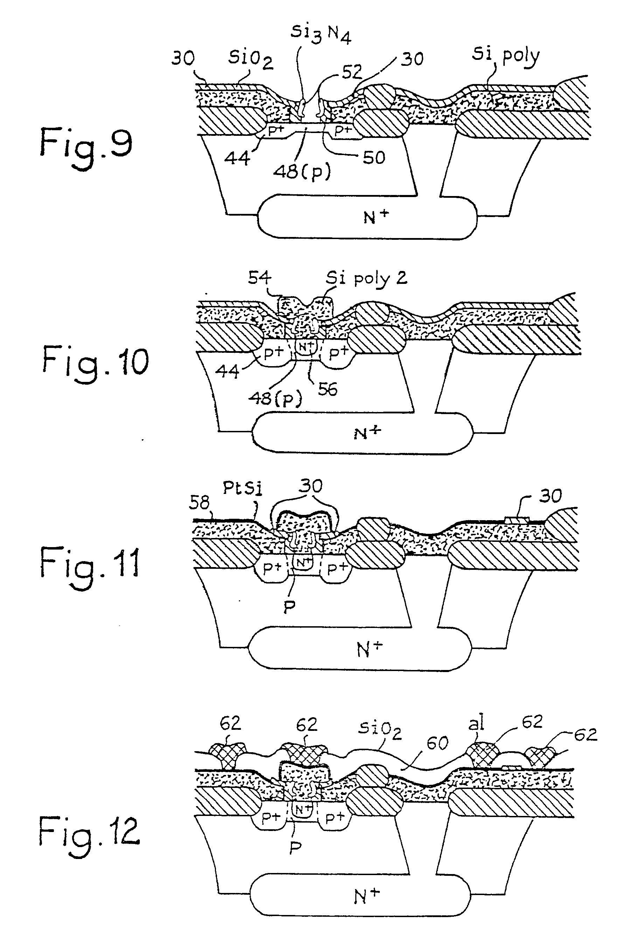

Après cette étape de dissolution du nitrure, on attaque l'oxyde 50 recouvrant la plaquette, mais seulement sur une épaisseur permettant de mettre à nu le silicium monocristallin dans l'ouverture 38, sans aller jusqu'à mettre à nu le silicium polycristallin. Ceci est facile car la couche d'oxyde 30 initialement déposée n'était pas présente dans l'ouverture 38 et subsiste donc après l'élimination de la couche 50. L'oxyde de la couche 50 subsiste cependant là où il est protégé par les portions restantes de nitrure. La partie de silicium monocristallin à nu est donc rétrécie par rapport à l'ouverture 38 formée dans le silicium polycristallin, mais elle reste centrée par rapport à cette ouverture. Le rétrécissement correspond en gros à la somme des épaisseurs d'oxyde et de nitrure déposées après la formation par implantation de la base intrinsèque (de l'ordre de 0,4 micron). Le silicium polycristallin 26 reste quant à lui complètement masqué par la couche isolante 30 (oxyde) qu'on a pris soin de ne pas éliminer en mettant à nu le silicium monocristallin à l'intérieur de l'ouverture 38 (figure 9).

On peut alors réaliser la région d'émetteur et son contact. Ce pourrait être par implantation ou diffusion de phosphore dans l'ouverture 38, puis dépôt sur la plaquette y compris dans cette ouverture d'un conducteur qu'on grave ensuite. On préfère déposer immédiatement une deuxième couche uniforme 54 de silicium polycristallin qui remplit l'ouverture 38 en venant en contact avec le silicium monocristallin. Cette deuxième couche est dopée au phosphore par exemple (N$^+$) soit pendant son dépôt, soit après ; dans les deux cas, la deuxième couche 54 de silicium polycristallin sert à la fois de contact d'émetteur et de source de dopant pour le silicium monocristallin, là où elle est en contact avec ce dernier, de sorte qu'elle crée une région d'émetteur 56 qui est alignée avec son contact et, comme on l'a expliqué, centrée par rapport à la base extrinsèque 44 et son contact.

La deuxième couche 54 de silicium polycristallin est gravée par plasma pour délimiter l'électrode d'émetteur ainsi que des interconnexions (figure 10).

Comme on l'a mentionné précédemment, on pourrait prévoir qu'avant le dépôt de la deuxième couche 54, la première couche 26 soit éliminée dans toute la région C (figure 4), c'est-à-dire en particulier dans tout l'espace entre des régions d'oxyde épais formées dans le silicium polycristallin 26. De cette manière, le deuxième niveau de silicium polycristallin 54 servirait aussi de contact de collecteur et serait donc gravé en conséquence.

On peut ensuite continuer le procédé selon l'invention en formant du siliciure de platine PtSi (58) sur les interconnexions après gravure de la couche de silice 30 (figure 11), pour améliorer la conductibilité des interconnexions. Puis, après dépôt et gravure d'une couche de silice 60 (figure 12), on procède au dépôt d'une couche d'aluminium 62 (qui constitue un troisième niveau d'interconnexion) qui est gravée selon les connexions à réaliser. Une passivation finale peut être effectuée.

On réalise ainsi des transistors très petits (émetteur de 0,5 micromètre de côté) qui, en fonctionnement logique, permettent d'atteindre des temps de propagation de 0,25 nanoseconde par porte avec un facteur de mérite de 0,15 picojoule, sans que ces performances soient liées aux précisions d'alignement des masques.

Bien entendu, on peut réaliser des transistors PNP en utilisant la même technique et en inversant les types de conductivité mentionnés dans la description.

**Revendications**

1. Procédé de fabrication d'un transistor bipolaire intégré, de très petites dimensions, dans lequel les étapes de formation de la base et de l'émetteur de ce transistor comprennent :

a) la formation, sur une couche de silicium monocristallin (16) d'un premier type de conductivité, d'une couche de silicium polycristallin (26), dopée au-dessus de la région de base avec une impureté d'un second type de conductivité,

b) la formation d'une couche isolante (30) sur le silicium polycristallin,

c) l'élimination de la couche isolante et du silicium polycristallin par gravure localisée jusqu'à mise à nu du silicium monocristallin au-dessus d'une région (48) qui constituera une base intrinsèque du transistor,

d) un traitement thermique assurant la diffusion dans la couche de silicium monocristallin (16) de l'impureté du second type présente dans le silicium polycristallin (16), pour constituer une région de base extrinsèque (44) entourant la région de base intriinsèque (48),

e) le dopage du silicium monocristallin dans la région de base intrinsèque (48) avec une impureté du second type de conductivité,

f) la formation d'une couche d'oxyde de silicium (50),

g) un dépôt uniforme en phase vapeur à basse pression d'une faible épaisseur de nitrure de silicium (52),

h) une implantation ionique verticale, dans le nitrure, d'une impureté susceptible d'augmenter la facilité de dissolution du nitrure,

i) une dissolution du nitrure sur ses portions horizontales seulement et une dissolution de l'oxyde déposé à l'étape f, pendant un temps suffisant pour mettre à nu le silicium monocristallin au centre de la région intrinsèque (48) mais insuffisant pour éliminer la couche isolante formée à l'étape b,

j) un dopage, avec une impureté du premier type de conductivité, de la région de silicium monocristallin mise à nu, avant ou après dépôt et gravure d'un contact conducteur d'émetteur (54) dans cette région, pour former une région d'émetteur (56) autoalignée avec son contact.

2. Procédé selon la revendication 1, caractérisé par le fait que l'étape a) comprend le dépôt d'une couche de silicium polycristallin sur une couche épitaxiale de silicium monocristallin puis, ultérieurement, le dopage, avec une impureté du second type, de la couche de silicium polycristallin dans des régions recouvrant notamment les régions de base, d'autres régions de silicium polycristallin étant protégées pendant ce dopage par une couche de protection gravée à l'aide d'un masque de sélection.

3. Procédé selon l'une quelconque des revendications 1 et 2, caractérisé par le fait que l'étape c) comprend une gravure par plasma ou par solution chimique du silicium polycristallin, le masque comprenant une ouverture (36) correspondant à la géométrie désirée pour la région d'émetteur, dilatée de quelques dixièmes de micromètre.

4. Procédé selon l'une quelconque des revendications 1 à 3, caractérisé en ce que l'oxyde de silicium déposé à l'étape f) a une épaisseur de l'ordre de 0,5 micromètre et le nitrure déposé à l'étape g) a une épaisseur de l'ordre de 0,05 micromètre.

5. Procédé selon l'une quelconque des revendication 1 à 4, caractérisé par le fait que la couche isolante formée à l'étape b) est une couche d'oxyde de silicium d'une épaisseur de l'ordre de 0,3 micromètre.

6. Procédé selon l'une quelconque des revendications 1 à 5, caractérisé en ce que l'impureté implantée à l'étape h) est du phosphore.


**Claims**

1. Method of producing a bipolar integrated transistor of very small dimensions, wherein the steps of forming the base and emitter of this transistor comprise :

a) on a monocrystalline silicon layer (16) of a first conductivity type a polycrystalline silicon layer (26) is formed which is doped above the base zone with an impurity of a second conductivity type,

b) an insulating layer (30) is formed on the polycrystalline silicon,

c) the insulating layer and the polycrystalline silicon are eliminated by localized engraving until the monocrystalline silicon is bared above a zone (48) which will form an intrinsic base of the transistor,

d) a thermal treatment ensuring the diffusion of the impurity of the second type present within the polycrystalline silicon (16) into the monocrystalline silicon layer (16) to form an extrinsic base zone (44) surrounding the intrinsic base zone (48),

e) the monocrystalline silicon is doped in the intrinsic base zone (48) with an impurity of the second conductivity type,

f) a silicon oxide layer (50) is formed,

g) a uniform deposit of a small thickness of silicon nitride (52) from the vapour phase at low pressure,

h) a vertical ion implantation into the nitride with an impurity susceptible to increase the facility of dissolution of the nitride,

i) a dissolution of the horizontal portions only of the nitride and a dissolution of the oxide formed in step f) for a time sufficient to uncover the monocrystalline silicon at the center of the intrinsic zone (48) but insufficient to eliminate the insulating layer formed in step b),

j) the uncovered zone of monocrystalline silicon is doped with an impurity of the first conductivity type prior to or after the deposit, and engraving of a conductive emitter contact (54) in this region to form an emitter zone (56) which is self-aligned with its contact.

2. Method according to claim 1, characterized by the fact that step a) comprises the deposit of a polycrystalline silicon layer on an epitaxial layer of monocrystalline silicon and, subsequently, the doping of the polycrystalline silicon layer with an impurity of the second type in the regions covering in particular the base zones, other zones of the polycrystalline silicon being protected during this doping by a protection layer which is engraved by means of a selection mask.

3. Method according to any of claims 1 and 2, characterized by the fact that step c) comprises the engraving of the polycrystalline silicon by means of a plasma or a chemical solution, the mask comprising an opening (36) corresponding to the desired geometry of the emitter zone, extended by several tenths of one micrometer.

4. Method according to any of claims 1 to 3, characterized in that the silicon oxide deposited in step f) has a thickness of the order of 0,5 micrometer and the nitride deposited in step g) has a thickness of the order of 0,05 micrometer.

5. Method according to any of claims 1 to 4, characterized by the fact that the insulating layer formed in step b) is a silicon oxide layer with a thickness of the order of 0,3 micrometer.

6. Method according to any of claims 1 to 5, characterized in that the impurity implanted in step h) is phosphorus.


**Patentansprüche**

1. Verfahren zur Herstellung eines bipolaren integrierten Transistors von sehr kleinen Abmessungen, bei welchem die Schritte zur Herstellung der Basis und des Emitters dieses Transistors umfassen :

a) auf einer Schicht aus monokristallinem Silizium (16) eines ersten Leitungstyps wird eine polykristalline Siliziumschicht (26) gebildet, welche oberhalb des Basisgebietes mit einer Verunreinigung eines zweiten Leitungstyps dotiert ist,

b) eine Isolierschicht (30) wird auf dem polykristallinen Silizium gebildet,

c) die Isolierschicht und das polykristalline Silizium werden durch örtliche Gravierung bis zum Bloßlegen des monokristallinen Siliziums oberhalb eines Bereiches (48) beseitigt, welcher eine Eigenleitungsbasis des Transistors bilden wird,

d) eine thermische Behandlung, welche die Diffusion der Verunreinigung des zweiten Typs, welche in dem polykristallinen Silizium (16) enthalten ist, in die monokristalline Siliziumschicht (16) gewährleistet, um ein Basisgebiet (44) mit Störstellenleitung zu bilden, welches das eigenleitende Basisgebiet (48) umgibt,

e) die Dotierung des monokristallinen Siliziums in dem eigenleitenden Basisgebiet (48) mit einer Verunreinigung des zweiten Leitungstyps,

f) die Bildung einer Siliziumoxidschicht (50),

g) die gleichförmige Ablagerung einer dünnen Schicht Siliziumnitrid (52) aus der Dampfphase unter niedrigem Druck,

h) vertikale Ionenimplantation einer Verunreinigung in das Nitrid, welche das Lösungsvermögen des Nitrids steigern soll,

i) Auflösen des Nitrids nur an den horizontalen Teilen und Auflösung des im Schritt f aufgebrachten Oxids während einer ausreichenden Zeit, um das monokristalline Silizium in der Mitte des eigenleitenden Gebiets (48) bloßzulegen, wobei diese Zeit jedoch nicht ausreicht, um die im Schritt b gebildete Isolierschicht zu beseitigen,

j) Dotierung des bloßgelegten monokristallinen Siliziumgebietes mit einer Verunreinigung des ersten Leitungstyps vor oder nach dem Aufbringen und Gravieren eines leitfähigen Emitterkontaktes (54) in diesem Gebiet, um einen Emitterbereich (56) zu bilden, der selbsttätig nach seinem Kontakt ausgerichtet ist.

2. Verfahren nach Anspruch 1, dadurch gekennzeichnet, daß der Schritt a das Aufbringen einer polykristallinen Siliziumschicht auf einer monokristallinen epitaktischen Siliziumschicht und anschließend die Dotierung der polykristallinen Siliziumschicht mit einer Verunreinigung des zweiten Typs in Gebieten umfaßt, welche insbesondere die Basisgebiete bedecken, wobei weitere Gebiete aus polykristallinem Silizium während dieser Dotierung durch eine Schutzschicht geschützt sind, welche unter Zuhilfenahme einer Selektionsmaske graviert wurde.

3. Verfahren nach Anspruch 1 oder 2, dadurch gekennzeichnet, daß der Schritt c ein Gravieren des polykristallinen Siliziums mittels Plasma oder einer chemischen Lösung umfaßt, wobei die Maske ferner eine Öffnung (36) aufweist, welche der gewünschten Geometrie des Emittergebietes entspricht, verbreitert um einige Zehntel Mikrometer.

4. Verfahren nach einem der Ansprüche 1 bis 3, dadurch gekennzeichnet, daß das im Schritt f aufgebrachte Siliziumoxid eine Dicke in der Größenordnung von 0,5 Mikrometer aufweist und das im Schritt g aufgebrachte Nitrid eine Dicke in der Größenordnung von 0,05 Mikrometer aufweist.

5. Verfahren nach einem der Ansprüche 1 bis 4, dadurch gekennzeichnet, daß die im Schritt b gebildete Isolierschicht eine Siliziumoxidschicht mit einer Dicke in der Größenordnung von 0,3 Mikrometer ist.

6. Verfahren nach einem der Ansprüche 1 bis 5, dadurch gekennzeichnet, daß die im Schritt h implantierte Verunreinigung Phosphor ist.

Fig. 1

Fig. 2

Fig. 3

Fig. 4

Fig.5

Fig.6

Fig.7

Fig.8

Fig.9

Fig.10

Fig.11

Fig.12